# EUROPEAN PATENT APPLICATION

(11) **EP 4 535 933 A1**
(43) Date of publication of application: **09.04.2025**
(21) Application number: 23852766.7
(22) Date of filing: 13.07.2023
(51) Int. Cl.: H05K 1/11, H05K 1/18

(54) **PRINTED CIRCUIT BOARD HAVING OPTIONAL CIRCUIT UNIT**

(30) Priority: 08.08.2022 KR 20220098545
(71) Applicant: Samsung Electronics Co., Ltd., Suwon-si, Gyeonggi-do 16677 (KR)
(72) Inventor: OH, Kihun, Suwon-si, Gyeonggi-do 16677 (KR)
(74) Representative: Gulde & Partner
(86) International application number: PCT/KR2023/010012
(87) International publication number: WO 2024/034884

(57) **Abstract**

A printed circuit board includes: a first via and a second via provided between a first circuit portion and a second circuit portion provided on an upper surface of an insulating layer, and penetrating the insulating layer; a first signal pad provided on the upper surface of the insulating layer so as to be connected to an upper end of the first via, and having only one pad connection portion; a second signal pad provided on the upper surface of the insulating layer so as to be connected to an upper end of the second via, and having only one pad connection portion; a first signal line connected to the first circuit portion and including a first pad provided adjacent to the first signal pad; a second signal line connected to the first circuit portion in parallel with the first signal line and including a second pad provided adjacent to the second signal pad; a third signal line connected to the second circuit portion and including a third pad provided adjacent to the first signal pad; a fourth signal line connected to the second circuit portion in parallel with the third signal line and including a fourth pad provided adjacent to the second signal pad; a first connecting element to connect the pad connection portion of the first signal pad to the first pad or the third pad; and a second connecting element to connect the pad connection portion of the second signal pad to the second pad or the fourth pad.

## Description

### [Technical Field]

The disclosure relates to a printed circuit board, and more particularly, a printed circuit board having an optional circuit portion.

### [Background Art]

Electronic products such as TVs, monitors, etc. may include printed circuit boards that have circuitry for controlling the electronic products.

However, because electronic products are produced and sold in various models, various types of printed circuit boards with circuitry suitable for each of the various models are used.

For example, a TV manufacturer may receive liquid crystal panels for manufacturing TVs from multiple liquid crystal panel manufacturers. In this case, multiple printed circuit boards corresponding to multiple liquid crystal panels manufactured by different manufacturers are used.

Therefore, some manufacturers use printed circuit boards that have two circuit portions corresponding to two types of liquid crystal panels on one printed circuit board in order to reduce the types of printed circuit boards used.

### [Disclosure of Invention]

### [Technical Solution]

According to one or more embodiments of the disclosure, a printed circuit board may include: an insulating layer; a first circuit portion and a second circuit portion provided on an upper surface of the insulating layer; a first via and a second via provided between the first circuit portion and the second circuit portion, and penetrating the insulating layer; a first signal pad provided between the first circuit portion and the second circuit portion on the upper surface of the insulating layer and configured to be connected to an upper end of the first via, and having only one pad connection portion; a second signal pad provided adjacent to the first signal pad between the first circuit portion and the second circuit portion on the upper surface of the insulating layer and configured to be connected to an upper end of the second via, and having only one pad connection portion; a first signal line connected to the first circuit portion on the upper surface of the insulating layer and including a first pad provided adjacent to the first signal pad; a second signal line connected to the first circuit portion in parallel with the first signal line on the upper surface of the insulating layer and including a second pad provided adjacent to the second signal pad; a third signal line connected to the second circuit portion on the upper surface of the insulating layer and including a third pad provided adjacent to the first signal pad; a fourth signal line connected to the second circuit portion in parallel with the third signal line on the upper surface of the insulating layer and including a fourth pad provided adjacent to the second signal pad; a first connecting element configured to connect the pad connection portion of the first signal pad to one of the first pad and the third pad; and a second connecting element configured to connect the pad connection portion of the second signal pad to one of the second pad and the fourth pad.

Based on using the first circuit portion, the first connecting element may be disposed to connect the pad connection portion of the first signal pad and the first pad, and the second connecting element may be disposed to connect the pad connection portion of the second signal pad and the second pad. Based on using the second circuit portion, the first connecting element may be disposed to connect the pad connection portion of the first signal pad and the third pad, and the second connecting element may be disposed to connect the pad connection portion of the second signal pad and the fourth pad.

The second circuit portion may be provided separately from the first circuit portion on the upper surface of the insulating layer.

A pair of lower signal lines may be provided on a lower surface of the insulating layer. A lower end of the first via and a lower end of the second via may be respectively connected to the pair of lower signal lines.

The first via and the second via may be provided inside the first pad, the second pad, the third pad, and the fourth pad.

The first pad of the first signal line and the third pad of the third signal line may be provided symmetrically with respect to the pad connection portion of the first signal pad. The second pad of the first signal line and the fourth pad of the fourth signal line may be provided symmetrically with respect to the pad connection portion of the second signal pad.

The pad connection portion of the first signal pad may be provided to be positioned in a straight line with the first pad of the first signal line and the third pad of the third signal line. The pad connection portion of the second signal pad may be provided to be positioned in a straight line with the second pad of the second signal line and the fourth pad of the fourth signal line.

The pad connection portion of the first signal pad may be provided to be positioned outside of a virtual straight line connecting the first pad of the first signal line and the third pad of the third signal line. The pad connection portion of the second signal pad may be provided to be positioned outside of a virtual straight line connecting the second pad of the second signal line and the fourth pad of the fourth signal line.

The first via and the second via may be provided outside of the first pad, the second pad, the third pad, and the fourth pad.

The first pad of the first signal line and the third pad of the third signal line may be provided symmetrically with respect to the pad connection portion of the first signal pad. The second pad of the first signal line and the fourth pad of the fourth signal line may be provided symmetrically with respect to the pad connection portion of the second signal pad.

The pad connection portion of the first signal pad may be provided to be positioned in a straight line with the first pad of the first signal line and the third pad of the third signal line. The pad connection portion of the second signal pad may be provided to be positioned in a straight line with the second pad of the second signal line and the fourth pad of the fourth signal line.

The pad connection portion of the first signal pad may be provided to be positioned above a virtual straight line connecting the first pad of the first signal line and the third pad of the third signal line. The pad connection portion of the second signal pad may be provided to be positioned below a virtual straight line connecting the second pad of the second signal line and the fourth pad of the fourth signal line.

A gap between the pad connection portion of the first signal pad and the first pad may be identical to a gap between the pad connection portion of the first signal pad and the third pad. A gap between the pad connection portion of the second signal pad and the second pad may be identical to a gap between the pad connection portion of the second signal pad and the fourth pad.

A gap between the pad connection portion of the first signal pad and the first pad may be identical to a gap between the pad connection portion of the second signal pad and the second pad. A gap between the pad connection portion of the first signal pad and the third pad may be identical to a gap between the pad connection portion of the second signal pad and the fourth pad.

The first connecting element and the second connecting element may include one of a resistor, a filter, a capacitor, and a conductor.

### [Brief Description of Drawings]

The above and/or other aspects, features, and advantages of certain embodiments of the present disclosure will be more apparent from the following detailed description, taken in conjunction with the accompanying drawings, in which:
FIG 1 is a plan view illustrating a printed circuit board according to one or more embodiments of the disclosure.
FIG 2 is a cross-sectional view illustrating the printed circuit board of FIG 1 taken along a line I-I.
FIG 3 is a partial perspective view illustrating a part A of the printed circuit board of FIG. 1.
FIG 4 is a partial perspective view illustrating another arrangement of a part A of the printed circuit board of FIG. 1.
FIG 5 is a plan view illustrating the part A of the printed circuit board of FIG. 4.
FIG 6 is a plan view illustrating a printed circuit board according to one or more embodiments of the disclosure.
FIG 7 is a partial perspective view illustrating a part B of the printed circuit board of FIG. 6.
FIG 8 is a plan view illustrating a printed circuit board according to one or more embodiments of the disclosure.
FIG 9 is a partial perspective view illustrating a part C of the printed circuit board of FIG 8.
FIG 10 is a plan view illustrating a printed circuit board according to one or more embodiments of the disclosure.
FIG 11 is a plan view illustrating a printed circuit board according to one or more embodiments of the disclosure.
FIG 12 is a graph comparing the insertion loss of a printed circuit board having a signal pad without a branch according to one or more embodiments of the disclosure and the insertion loss of a printed circuit board having a signal pad with a branch.
FIG 13 is an eye diagram of a two-layer printed circuit board according to one or more embodiments of the disclosure.
FIG 14 is an eye diagram of a two-layer printed circuit board using a signal pad with a branch.
FIG 15 is an eye diagram of a four-layer printed circuit board using a signal pad with a branch.

### [Best Mode for Carrying out the Invention]

Since various embodiments of the disclosure can apply various transformations and have various embodiments, example embodiments will be illustrated in the drawings and described in greater detail in the detailed description. However, this is not intended to limit the scope to the example embodiments, and should be understood to include various modifications, equivalents, and/or alternatives of the various example embodiments of the disclosure. In connection with the description of the drawings, like reference numerals may be used for like elements.

In describing the disclosure, when it is determined that a detailed description of a related known function or configuration may unnecessarily obscure the gist of the disclosure, a detailed description thereof may be omitted.

In addition, the following example embodiments may be modified in many different forms, and the scope of the technical idea of the disclosure is not limited to the following example embodiments. Rather, these embodiments are provided so that this disclosure will be thorough and complete, and will fully convey the spirit of the disclosure to those skilled in the art.

Terms used in this disclosure are only used to describe specific embodiments, and are not intended to limit the scope of rights. Singular expressions include plural expressions unless the context clearly dictates otherwise.

In this disclosure, expressions such as "has," "can have", "includes," or "can include" indicate the existence of a corresponding feature (e.g., numerical value, function, operation, or component such as a part) and do not preclude the existence of additional features.

In this disclosure, expressions such as "A or B," "at least one of A or/and B," or "one or more of A or/and B" may include all possible combinations of the items listed together. For example, "A or B," "at least one of A or/and B," or "one or more of A or/and B" may refer to all cases (1) including at least one A, (2) including at least one B, or (3) including both at least one A and at least one B.

Expressions such as "first," "second," "primary," or "secondary," as used in this disclosure may modify various components regardless of order and/or importance, are used only to distinguish one component from other components, and do not limit the corresponding components.

Further, terms such as 'leading end', 'rear end', 'upper side', 'lower side', 'top end', 'bottom end', etc. used in the disclosure are defined with reference to the drawings. However, the shape and position of each component are not limited by these terms.

The disclosure relates to a printed circuit board having a structure in which two circuit portions are provided on a printed circuit board and a signal line may be selectively connected to one of the two circuit portions. In other words, the disclosure relates to a printed circuit board having selectable optional circuit portions.

Hereinafter, a printed circuit board according to one or more embodiments of the disclosure will be described in detail with reference to the attached drawings.

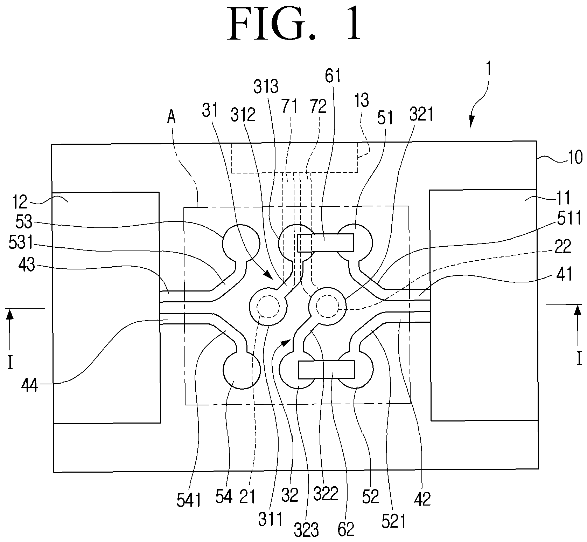

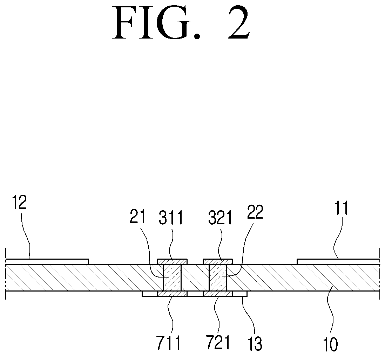

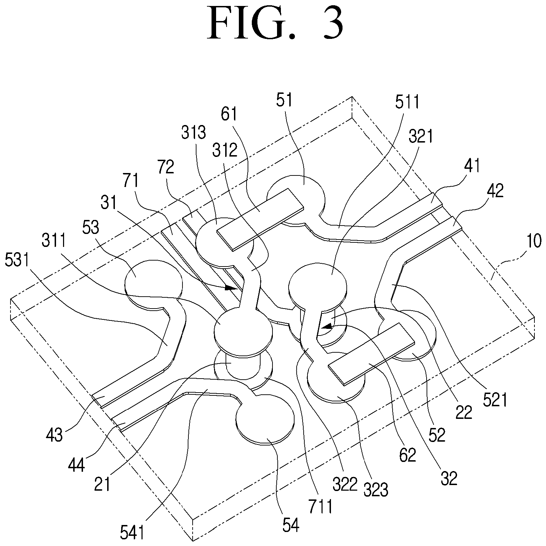

FIG 1 is a plan view illustrating a printed circuit board according to one or more embodiments of the disclosure. FIG 2 is a cross-sectional view illustrating the printed circuit board of FIG 1 taken along a line I-I. FIG 3 is a partial perspective view illustrating a part A of the printed circuit board of FIG 1.

Referring to FIGS. 1 to 3, a printed circuit board 1 according to one or more embodiments of the disclosure may include an insulating layer 10, and a first circuit portion 11 and a second circuit portion 12 provided on an upper surface of the insulating layer 10.

The insulating layer 10 may form a base of the printed circuit board 1. Conductive circuit lines may be provided on the upper surface and the lower surface of the insulating layer 10.

The first circuit portion 11 and the second circuit portion 12 may be provided on the upper surface of the insulating layer 10. The first circuit portion 11 and the second circuit portion 12 may be formed separately. In other words, functions that may be implemented by the first circuit portion 11 may be formed differently from functions that may be implemented by the second circuit portion 12.

For example, the first circuit portion 11 may be configured to operate a liquid crystal panel manufactured by Company A, and the second circuit portion 12 may be configured to operate a liquid crystal panel manufactured by Company B.

Alternatively, the first circuit portion 11 may be configured to operate a washing machine, and the second circuit portion 12 may be configured to operate a dryer.

The first circuit portion 11 and the second circuit portion 12 may be provided to be spaced apart from each other by a certain distance on the upper surface of the insulating layer 10. In other words, the first circuit portion 11 and the second circuit portion 12 may be provided so as not to be electrically connected to each other.

A pair of vias 21 and 22 may be provided between the first circuit portion 11 and the second circuit portion 12. The pair of vias 21 and 22 may be formed to penetrate the insulating layer 10. In other words, the pair of vias 21 and 22 may be formed to penetrate a portion of the insulating layer 10 between the first circuit portion 11 and the second circuit portion 12.

The pair of vias, that is, a first via 21 and a second via 22, may be formed at a certain distance apart and parallel to each other. The first via 21 and the second via 22 may be formed of a conductor.

The upper end of the first via 21 may be connected to a first signal pad 31. The first signal pad 31 may be configured to be connected to the upper end of the first via 21 on the upper surface of the insulating layer 10. The first signal pad 31 may be provided between the first circuit portion 11 and the second circuit portion 12. The first signal pad 31 may include only one pad connection portion 313.

The first signal pad 31 may include a via connection portion 311 connected to the upper end of the first via 21, an extension line 312 extended from the via connection portion 311, and the pad connection portion 313 provided at one end of the extension line 312. The extension line 312 may be provided to connect the via connection portion 311 and the pad connection portion 313. The width of the extension line 312 may be formed narrower than the widths of the via connection portion 311 and the pad connection portion 313.

The extension line 312 of the first signal pad 31 may be formed as a straight line, a bent straight line, or a curved line depending on the arrangement of the via connection portion 311 and the pad connection portion 313. In the case of the embodiment illustrated in FIGS. 1 and 3, the extension line 312 of the first signal pad 31 may be formed as a straight line bent at a certain angle.

The first signal pad 31 may be formed in a shape without a branch. In other words, only one extension line 312 is connected to the via connection portion 311. When the first signal pad 31 has a branch, two or more extension lines may be connected to the via connection portion 311. When the first signal pad 31 includes a branch, a signal transmitted to the first signal pad 31 through the first via 21 may branch and flow along two or more extension lines. However, in the case of the disclosure, because the first signal pad 31 does not include a branch, a signal may flow along only one extension line 312.

The upper end of the second via 22 may be connected to a second signal pad 32. The second signal pad 32 may be formed to be connected to the upper end of the second via 22 on the upper surface of the insulating layer 10. The second signal pad 32 may be provided adjacent to the first signal pad 31 between the first circuit portion 11 and the second circuit portion 12. The second signal pad 32 may include only one pad connection portion 323.

The second signal pad 32 may include a via connection portion 321 connected to the upper end of the second via 22, an extension line 322 extended from the via connection portion 321, and the pad connection portion 323 provided at one end of the extension line 322. The extension line 322 may be provided to connect the via connection portion 321 and the pad connection portion 323. The width of the extension line 322 may be formed narrower than the widths of the via connection portion 321 and the pad connection portion 323.

The extension line 322 of the second signal pad 32 may be formed as a straight line, a bent straight line, or a curved line depending on the arrangement of the via connection portion 321 and the pad connection portion 323. In the case of the embodiment illustrated in FIGS. 1 and 3, the extension line 322 of the second signal pad 32 may be formed as a straight line bent at a certain angle.

The second signal pad 32 may be formed in a shape without a branch. In other words, only one extension line 322 is connected to the via connection portion 321. When the second signal pad 32 has a branch, two or more extension lines may be connected to the via connection portion 321. When the second signal pad 32 includes a branch, a signal transmitted to the second signal pad 32 through the second via 22 may branch and flow along two or more extension lines. However, in the case of the disclosure, because the second signal pad 32 does not include a branch, a signal may flow along only one extension line 322.

The first signal pad 31 and the second signal pad 32 may be formed to be symmetrical to each other.

The first circuit portion 11 may include a pair of signal lines 41 and 42. The pair of signal lines 41 and 42 may be configured to selectively connect the first signal pad 31 and the second signal pad 32 to first circuit portion 11.

The pair of signal lines, that is, a first signal line 41 and a second signal line 42, may be provided parallel to each other on the upper surface of the insulating layer 10, and configured to be connected to the first circuit portion 11. The first signal line 41 and the second signal line 42 may be spaced apart from each other by a certain distance and may be formed parallel to each other.

One end of the first signal line 41 may be provided adjacent to the first signal pad 31. A first pad 51 may be provided at one end of the first signal line 41. The first pad 51 may be formed with a width wider than the width of the first signal line 41. The first pad 51 may be connected to the first signal line 41 through a first connection line 511. The first connection line 511 may be formed to be bent at a certain angle with respect to the first signal line 41.

The first pad 51 may be provided adjacent to the first signal pad 31. In detail, the first pad 51 may be provided adjacent to the pad connection portion 313 of the first signal pad 31.

One end of the second signal line 42 may be provided adjacent to the second signal pad 32. A second pad 52 may be provided at one end of the second signal line 42. The second pad 52 may be formed with a width wider than the width of the second signal line 42. The second pad 52 may be connected to the second signal line 42 through a second connection line 521. The second connection line 521 may be formed to be bent at a certain angle with respect to the second signal line 42.

The second pad 52 may be provided adjacent to the second signal pad 32. In detail, the second pad 52 may be provided adjacent to the pad connection portion 323 of the second signal pad 32.

The second circuit portion 12 may include a pair of signal lines 43 and 44. The pair of signal lines 43 and 44 may be configured to selectively connect the first signal pad 31 and the second signal pad 32 to the second circuit portion 12.

The pair of signal lines, that is, a third signal line 43 and a fourth signal line 44, may be provided parallel to each other on the upper surface of the insulating layer 10, and configured to be connected to the second circuit portion 12. The third signal line 43 and the fourth signal line 44 may be spaced apart from each other by a certain distance and may be formed parallel to each other.

As an example, the third signal line 43 and the fourth signal line 44 of the second circuit portion 12 may be formed symmetrically with the first signal line 41 and the second signal line 42 of the first circuit portion 11. In other words, the third signal line 43 of the second circuit portion 12 may be arranged in a straight line with the first signal line 41 of the first circuit portion 11, and the fourth signal line 44 of the second circuit portion 12 may be arranged in a straight line with the second signal line 42 of the first circuit portion 11.

The first via 21 and the second via 22 may be arranged parallel to the first signal line 41 and the second signal line 42. For example, a virtual straight line connecting the first via 21 and the second via 22 may be parallel to the first signal line 41 and the second signal line 42. In addition, the first via 21 and the second via 22 may be arranged parallel to the third signal line 43 and the fourth signal line 44. For example, the virtual straight line connecting the first via 21 and the second via 22 may be parallel to the third signal line 43 and the fourth signal line 44.

One end of the third signal line 43 may be provided adjacent to the first signal pad 31. A third pad 53 may be provided at one end of the third signal line 43. The third pad 53 may be formed with a width wider than the width of the third signal line 43. The third pad 53 may be connected to the third signal line 43 through a third connection line 531. The third connection line 531 may be formed to be bent at a certain angle with respect to the third signal line 43.

The third pad 53 may be provided adjacent to the first signal pad 31. In detail, the third pad 53 may be provided adjacent to the pad connection portion 313 of the first signal pad 31. The third pad 53 may be provided on the opposite side of the first pad 51 based on the pad connection portion 313 of the first signal pad 31.

The third pad 53 may be arranged symmetrically with respect to the pad connection portion 313 of the first signal pad 31. For example, the third pad 53 may be arranged to form a straight line with the pad connection portion 313 of the first signal pad 31 and the first pad 51.

One end of the fourth signal line 44 may be provided adjacent to the second signal pad 32. A fourth pad 54 may be provided at one end of the fourth signal line 44. The fourth pad 54 may be formed with a width wider than the width of the fourth signal line 44. The fourth pad 54 may be connected to the fourth signal line 44 through a fourth connection line 541. The fourth connection line 541 may be formed to be bent at a certain angle with respect to the fourth signal line 44.

The fourth pad 54 may be provided adjacent to the second signal pad 32. In detail, the fourth pad 54 may be provided adjacent to the pad connection portion 323 of the second signal pad 32. The fourth pad 54 may be provided on the opposite side of the second pad 52 based on the pad connection portion 323 of the second signal pad 32.

The fourth pad 54 may be arranged symmetrically with respect to the pad connection portion 323 of the second signal pad 32. For example, the fourth pad 54 may be arranged to form a straight line with the pad connection portion 323 of the second signal pad 32 and the second pad 52.

The pair of vias, that is, the first via 21 and the second via 22, may be provided inside the first pad 51 and the second pad 52 connected to the first circuit portion 11 and the third pad 53 and the fourth pad 54 connected to the second circuit portion 12. For example, the first pad 51, the second pad 52, the third pad 53, and the fourth pad 54 may be arranged in a rectangular shape. Accordingly, the first via 21 and the second via 22 may be positioned inside the rectangle formed by the first pad 51, the second pad 52, the third pad 53, and the fourth pad 54.

The pad connection portion 313 of the first signal pad 31 may be arranged in the center between the first pad 51 of the first signal line 41 and the third pad 53 of the third signal line 43. The pad connection portion 313 of the first signal pad 31 may be arranged between the first pad 51 and the second pad 52 to form a straight line with the first pad 51 and the third pad 53.

The pad connection portion 323 of the second signal pad 32 may be arranged in the center between the second pad 52 of the second signal line 42 and the fourth pad 54 of the fourth signal line 44. The pad connection portion 323 of the second signal pad 32 may be arranged between the second pad 52 and the fourth pad 54 to form a straight line with the second pad 52 and the fourth pad 54.

The gap between the pad connection portion 313 of the first signal pad 31 and the first pad 51 may be the same as the gap between the pad connection portion 313 of the first signal pad 31 and the third pad 53. The gap between the pad connection portion 323 of the second signal pad 32 and the second pad 52 may be the same as the gap between the pad connection portion 323 of the second signal pad 32 and the fourth pad 54.

The gap between the pad connection portion 313 of the first signal pad 31 and the first pad 51 may be the same as the gap between the pad connection portion 323 of the second signal pad 32 and the second pad 52. The gap between the pad connection portion 313 of the first signal pad 31 and the third pad 53 may be the same as the gap between the pad connection portion 323 of the second signal pad 32 and the fourth pad 54.

The pair of signal pads 31 and 32 may be selectively connected to one of the pair of signal lines 41 and 42 of the first circuit portion 11 and the pair of signal lines 43 and 44 of the second circuit portion 12 by a pair of connecting elements 61 and 62.

For example, the first signal pad 31 may be connected to the first pad 51 of the first signal line 41 connected to the first circuit portion 11 or to the third pad 53 of the third signal line 43 connected to the second circuit portion 12 by a first connecting element 61. The second signal pad 32 may be connected to the second pad 52 of the second signal line 42 connected to the first circuit portion 11 or to the fourth pad 54 of the fourth signal line 44 connected to the second circuit portion 12 by a second connecting element 62.

When using the first circuit portion 11, the first pad 51 of the first signal line 41 is connected to the pad connection portion 313 of the first signal pad 31 by the first connecting element 61, and the second pad 52 of the second signal line 42 is connected to the pad connection portion 323 of the second signal pad 32 by the second connecting element 62. Then, signals transmitted to the first signal pad 31 and the second signal pad 32 through the first via 21 and the second via 22 may be transmitted to the first circuit portion 11 through the first signal line 41 and the second signal line 42.

When using the second circuit portion 12, the third pad 53 of the third signal line 43 is connected to the pad connection portion 313 of the first signal pad 31 by the first connecting element 61, and the fourth pad 54 of the fourth signal line 44 is connected to the pad connection portion 323 of the second signal pad 32 by the second connecting element 62. Then, signals transmitted to the first signal pad 31 and the second signal pad 32 through the first via 21 and the second via 22 may be transmitted to the second circuit portion 12 through the third signal line 43 and the fourth signal line 44.

The connecting elements 61 and 62 may be formed of an element that connects the pad connection portions 313 and 323 of the signal pads 31 and 32 and the pads 51, 52, 53, and 54 of the signal lines 41, 42, 43, and 44 to allow signals to flow therebetween. For example, the connecting elements 61 and 62 may be formed of one of a resistor, a filter, a capacitor, and a conductor. In other words, the first connecting element 61 and the second connecting element 62 may include one of a resistor, a filter, a capacitor, and a conductor. In this case, the first connecting element 61 and the second connecting element 62 may be formed identically.

A pair of lower signal lines 71 and 72 may be provided on the lower surface of the insulating layer 10. The pair of lower signal lines 71 and 72 may be spaced apart by a certain distance and may be provided in parallel with each other.

The pair of lower signal lines 71 and 72 may be connected to a third circuit portion 13. The third circuit portion 13 may be provided on the lower surface of the insulating layer 10. The third circuit portion 13 may include a processor, a connector, etc.

The pair of vias, that is, the first via 21 and the second via 22, formed to penetrate the insulating layer 10 may be connected to the pair of lower signal lines 71 and 72. The gap between the pair of lower signal lines 71 and 72 may be formed narrower than the gap between the first via 21 and the second via 22.

The lower end of the first via 21 may be connected to one of the pair of lower signal lines 71 and 72 provided on the lower surface of the insulating layer 10, that is, a first lower signal line 71. The lower end of the second via 22 may be connected to the other of the pair of the lower signal lines 71 and 72 provided on the lower surface of the insulating layer 10, that is, a second lower signal line 72.

A first lower signal pad 711 may be provided at one end of the first lower signal line 71 connected to the lower end of the first via 21. The first lower signal pad 711 is connected to the lower end of the first via 21. A second lower signal pad 721 may be provided at one end of the second lower signal line 72 connected to the lower end of the second via 22. The second lower signal pad 721 is connected to the lower end of the second via 22. Therefore, the first via 21 and the second via 22 are electrically connected to the first lower signal line 71 and the second lower signal line 72, respectively.

Accordingly, signals transmitted through the first lower signal line 71 and the second lower signal line 72 may be transmitted to the first via 21 and the second via 22 through the first lower signal pad 711 and the second lower signal pad 721. The signals input to the first via 21 and the second via 22 may be transmitted to the first signal pad 31 and the second signal pad 32.

As illustrated in FIGS. 1 and 3, when the first connecting element 61 is disposed to connect the pad connection portion 313 of the first signal pad 31 and the first pad 51 of the first signal line 41 and the second connecting element 62 is disposed to connect the pad connection portion 323 of the second signal pad 32 and the second pad 52 of the second signal line 42, the signals transmitted to the first signal pad 31 and the second signal pad 32 are transmitted to the first signal line 41 and the second signal line 42 through the first connecting element 61 and the second connecting element 62. Then, the signals of the first lower signal line 71 and the second lower signal line 72 may be transmitted to the first circuit portion 11 through the first signal line 41 and the second signal line 42.

When the first connecting element 61 is disposed to connect the pad connection portion 313 of the first signal pad 31 and the third pad 53 of the third signal line 43 and the second connecting element 62 is disposed to connect the pad connection portion 323 of the second signal pad 32 and the fourth pad 54 of the fourth signal line 44, the signals transmitted to the first signal pad 31 and the second signal pad 32 are transmitted to the third signal line 43 and the fourth signal line 44 through the first connecting element 61 and the second connecting element 62. Then, the signals of the first lower signal line 71 and the second lower signal line 72 may be transmitted to the second circuit portion 12 through the third signal line 43 and the fourth signal line 44.

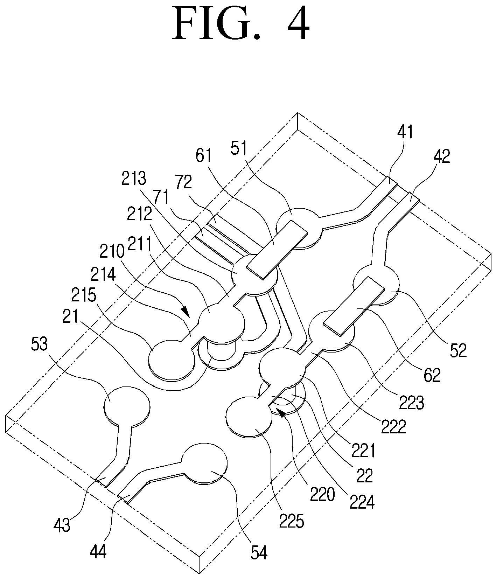

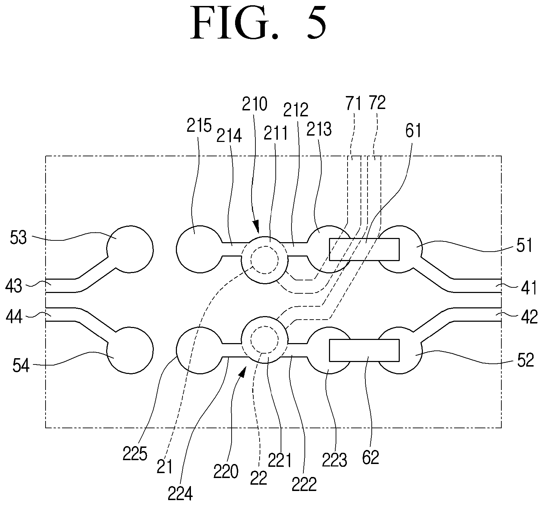

A printed circuit board including a signal pad with a branch will be described with reference to FIGS. 4 and 5.

FIG 4 is a partial perspective view illustrating another arrangement of a part A of the printed circuit board of FIG 1. FIG 5 is a plan view illustrating the part A of the printed circuit board of FIG 4.

Referring to FIGS. 4 and 5, a pair of vias 21 and 22 may be provided between the first circuit portion 11 and the second circuit portion 12. The pair of vias, that is, the first via 21 and the second via 22, may be formed to penetrate a portion of the insulating layer 10 between the first circuit portion 11 and the second circuit portion 12.

The first via 21 and the second via 22, may be formed at a certain distance apart and parallel to each other. The first via 21 and the second via 22 may be formed of a conductor.

The upper end of the first via 21 may be connected to a first signal pad 210. The first signal pad 210 may be configured to be connected to the upper end of the first via 21 on the upper surface of the insulating layer 10. The first signal pad 210 may be provided between the first circuit portion 11 and the second circuit portion 12. The first signal pad 210 may include two pad connection portions 213 and 215.

The first signal pad 210 may include a via connection portion 211 connected to the upper end of the first via 21, a first extension line 212 and a second extension line 214 extending from the via connection portion 211, and a first pad connection portion 213 and a second pad connection portion 215 provided at each end of the first extension line 212 and the second extension line 214.

The first extension line 212 may be provided to connect the via connection portion 211 and the first pad connection portion 213, and the second extension line 214 may be provided to connect the via connection portion 211 and the second pad connection portion 215. The width of each of the first extension line 212 and the second extension line 214 may be formed narrower than the width of each of the via connection portion 211, the first pad connection portion 213, and the second pad connection portion 215.

The first signal pad 210 may be formed in a shape having a branch. In other words, two extension lines 212 and 214 are connected to the via connection portion 211 of the first signal pad 210. When the first signal pad 210 does not have a branch, only one extension line may be connected to the via connection portion 211.

As illustrated in FIGS. 4 and 5, when the first signal pad 210 includes a branch, a signal transmitted to the first signal pad 210 through the first via 21 may branch and flow along the two extension lines 212 and 214. The signal branched by the first signal pad 210 may generate noise in the signal transmitted to the circuit portions 11 and 12.

The upper end of the second via 22 may be connected to a second signal pad 220. The second signal pad 220 may be configured to be connected to the upper end of the second via 22 on the upper surface of the insulating layer 10. The second signal pad 220 may be provided adjacent to the first signal pad 210 between the first circuit portion 11 and the second circuit portion 12. The second signal pad 220 may include two pad connection portions 223 and 225. The second signal pad 220 may be formed in the same shape as the first signal pad 210.

The second signal pad 220 may include a via connection portion 221 connected to the upper end of the second via 22, a first extension line 222 and a second extension line 224 extending from the via connection portion 221, and a first pad connection portion 223 and a second pad connection portion 225 provided at one end of each of the first extension line 222 and the second extension line 224.

The first extension line 222 may be provided to connect the via connection portion 221 and the first pad connection portion 223, and the second extension line 224 may be provided to connect the via connection portion 221 and the second pad connection portion 225. The width of each of the first extension line 222 and the second extension line 224 may be formed narrower than the width of each of the via connection portion 221, the first pad connection portion 223, and the second pad connection portion 225.

The second signal pad 220 may be formed in a shape having a branch. In other words, two extension lines 222 and 224 are connected to the via connection portion 221 of the first signal pad 220. When the second signal pad 220 does not have a branch, only one extension line may be connected to the via connection portion 221.

As illustrated in FIGS. 4 and 5, when the second signal pad 220 includes a branch, a signal transmitted to the second signal pad 210 through the second via 22 may branch and flow along the two extension lines 222 and 224. The signal branched by the second signal pad 220 may generate noise in the signal transmitted to the circuit portions 11 and 12.

A first pad 51, a second pad 52, a third pad 53, and a fourth pad 54 are arranged around the first signal pad 210 and the second signal pad 220. The first pad 51 and the second pad 52 are connected to the first circuit portion 11 through the first signal line 41 and the second signal line 42. The third pad 53 and the fourth pad 54 are connected to the second circuit portion 12 through the third signal line 43 and the fourth signal line 44.

A first connecting element 61 connects the first pad connection portion 213 of the first signal pad 210 and the first pad 51 of the first signal line 41, and a second connecting element 62 connects the second pad connection portion 223 of the second signal pad 220 and the second pad 52 of the second signal line 42.

The first circuit portion 11, the second circuit portion 12, the first pad 51, the second pad 52, the third pad 53, the fourth pad 54, the first connecting element 61, and the second connecting element 62 are identical or similar to those of the printed circuit board 1 according to the above-described embodiment, so detailed descriptions thereof are omitted.

Hereinafter, with reference to FIG 5, the flow of signals flowing through the first signal pad 210 and the second signal pad 220 having branches will be described in detail.

A signal input to the first signal pad 210 through the first via 21 flows to the first pad 51 of the first signal line 41 through the first extension line 212, the first pad connection portion 213, and the first connecting element 61. Some of the signal input to the first signal pad 210 flows to the second pad connection portion 215 through the second extension line 214. That is, the second extension line 214 and the second pad connection portion 215 form a short branch line (stub). A signal flowing through the branch line is reflected by one end of the second pad connection portion 215, and then flows to the first pad 51 of the first signal line 41 through the second extension line 214, the first extension line 212, the first pad connection portion 213, and the first connecting element 61. In this way, the signal reflected by one end of the second pad connection portion 215 and flowing to the first signal line 41 becomes a reflected wave, thereby generating noise in the signal flowing through the first signal line 41. Therefore, the quality of the signal flowing through the first signal line 41 may be degraded.

A signal input to the second signal pad 220 through the second via 22 may also generate noise in the signal flowing through the second signal line 42 in the same way as the signal input to the first signal pad 210 through the first via 21 described above. Accordingly, the quality of the signal flowing through the second signal line 42 may be degraded.

As described above, when the signal pads 210 and 220 have branches, noise may be generated by the signal flowing along the branches, so the quality of the signal transmitted to the circuit portions 11 and 12 through the signal pads 210 and 220 may deteriorate. However, when the signal pads 31 and 32 do not have branches, such as the printed circuit board 1 according to one or more embodiments of the disclosure, noise due to the branches is not generated, so the quality of the signal transmitted to the circuit portions 11 and 12 through the signal pads 31 and 32 may be improved.

Hereinafter, various arrangements of the first signal pad 31, the second signal pad 32, the first pad 51, the second pad 52, the third pad 53, and the fourth pad 54 will be described with reference to the attached drawings.

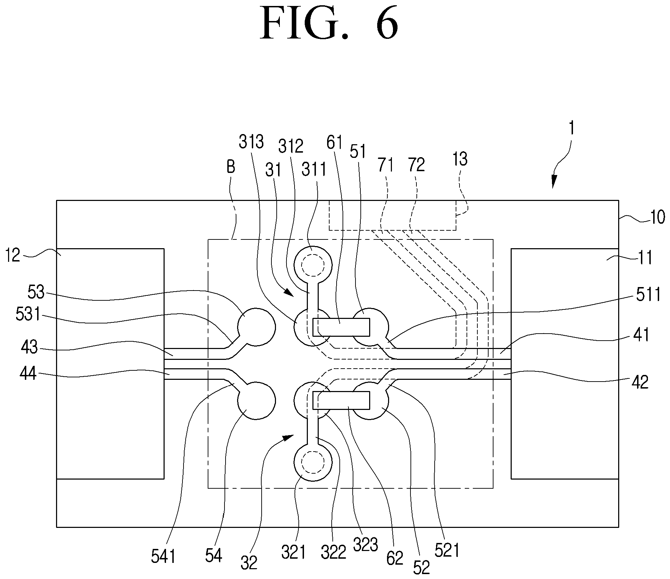

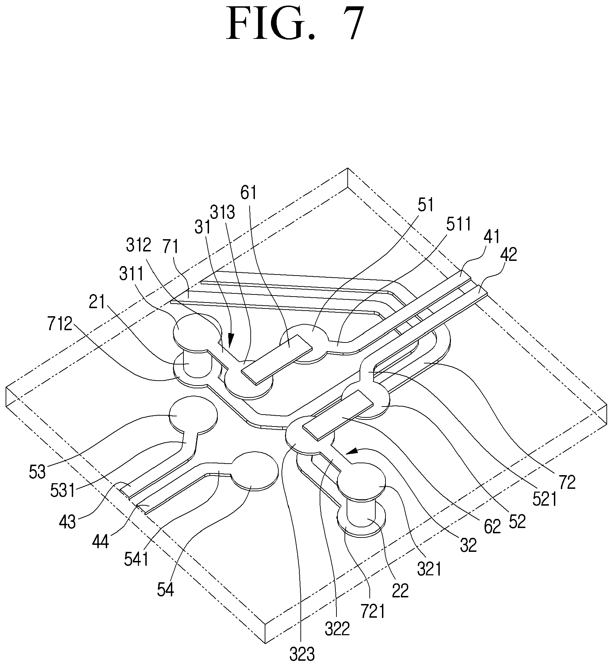

FIG 6 is a plan view illustrating a printed circuit board according to one or more embodiments of the disclosure. FIG 7 is a partial perspective view illustrating a part B of the printed circuit board of FIG 6.

Referring to FIGS. 6 and 7, a printed circuit board 1 according to one or more embodiments of the disclosure may include an insulating layer 10, and a first circuit portion 11 and a second circuit portion 12 provided on an upper surface of the insulating layer 10.

The insulating layer 10 may form a base of the printed circuit board 1. Conductive circuit lines may be provided on the upper surface and the lower surface of the insulating layer 10.

The first circuit portion 11 and the second circuit portion 12 may be provided on the upper surface of the insulating layer 10. The first circuit portion 11 and the second circuit portion 12 may be formed separately. In other words, functions that may be implemented by the first circuit portion 11 may be formed differently from functions that may be implemented by the second circuit portion 12.

The first circuit portion 11 and the second circuit portion 12 may be provided to be spaced apart from each other by a certain distance on the upper surface of the insulating layer 10. In other words, the first circuit portion 11 and the second circuit portion 12 may be provided so as not to be electrically connected to each other.

A pair of vias 21 and 22 may be provided between the first circuit portion 11 and the second circuit portion 12. The pair of vias 21 and 22 may be formed to penetrate the insulating layer 10. In other words, the pair of vias 21 and 22 may be formed to penetrate a portion of the insulating layer 10 between the first circuit portion 11 and the second circuit portion 12.

The pair of vias, that is, a first via 21 and a second via 22, may be formed at a certain distance apart and parallel to each other. The first via 21 and the second via 22 may be formed of a conductor.

The upper end of the first via 21 may be connected to a first signal pad 31. The first signal pad 31 may be configured to be connected to the upper end of the first via 21 on the upper surface of the insulating layer 10. The first signal pad 31 may be provided between the first circuit portion 11 and the second circuit portion 12. The first signal pad 31 may include only one pad connection portion 313.

The first signal pad 31 may include a via connection portion 311 connected to the upper end of the first via 21, an extension line 312 extended from the via connection portion 311, and the pad connection portion 313 provided at one end of the extension line 312. The extension line 312 may be provided to connect the via connection portion 311 and the pad connection portion 313. The width of the extension line 312 may be formed narrower than the widths of the via connection portion 311 and the pad connection portion 313. In the case of the embodiment illustrated in FIGS. 6 and 7, the extension line 312 may be formed in a straight line.

The first signal pad 31 may be formed in a shape without a branch. In other words, only one extension line 312 is connected to the via connection portion 311. When the first signal pad 31 has a branch, two or more extension lines may be connected to the via connection portion 311. When the first signal pad 31 includes a branch, a signal transmitted to the first signal pad 31 through the first via 21 may branch and flow along two or more extension lines. However, in the case of the disclosure, because the first signal pad 31 does not include a branch, a signal may flow along only one extension line 312.

The upper end of the second via 22 may be connected to a second signal pad 32. The second signal pad 32 may be configured to be connected to the upper end of the second via 22 on the upper surface of the insulating layer 10. The second signal pad 32 may be provided adjacent to the first signal pad 31 between the first circuit portion 11 and the second circuit portion 12. The second signal pad 32 may include only one pad connection portion 323.

The second signal pad 32 may include a via connection portion 321 connected to the upper end of the second via 22, an extension line 322 extending from the via connection portion 321, and the pad connection portion 323 provided at one end of the extension line 322. The extension line 322 may be provided to connect the via connection portion 321 and the pad connection portion 323. The width of the extension line 322 may be formed narrower than the widths of the via connection portion 321 and the pad connection portion 323. In the case of the embodiment illustrated in FIGS. 6 and 7, the extension line 322 of the second signal pad 32 may be formed in a straight line.

The second signal pad 32 may be formed in a shape without a branch. In other words, only one extension line 322 is connected to the via connection portion 321. When the second signal pad 32 has a branch, two or more extension lines may be connected to the via connection portion 321. When the second signal pad 32 includes a branch, a signal transmitted to the second signal pad 32 through the second via 22 may branch and flow along two or more extension lines. However, in the case of the disclosure, because the second signal pad 32 does not include a branch, a signal may flow along only one extension line 322.

The first signal pad 31 and the second signal pad 32 may be formed to be symmetrical to each other.

The first circuit portion 11 may include a pair of signal lines 41 and 42. The pair of signal lines 41 and 42 may be configured to selectively connect the first signal pad 31 and the second signal pad 32 to first circuit portion 11.

The pair of signal lines, that is, a first signal line 41 and a second signal line 42, may be provided parallel to each other on the upper surface of the insulating layer 10, and configured to be connected to the first circuit portion 11. The first signal line 41 and the second signal line 42 may be spaced apart from each other by a certain distance and may be formed parallel to each other.

One end of the first signal line 41 may be provided adjacent to the first signal pad 31. A first pad 51 may be provided at one end of the first signal line 41. The first pad 51 may be formed with a width wider than the width of the first signal line 41. The first pad 51 may be connected to the first signal line 41 through a first connection line 511. The first connection line 511 may be formed to be bent at a certain angle with respect to the first signal line 41.

The first pad 51 may be provided adjacent to the first signal pad 31. In detail, the first pad 51 may be provided adjacent to the pad connection portion 313 of the first signal pad 31.

One end of the second signal line 42 may be provided adjacent to the second signal pad 32. A second pad 52 may be provided at one end of the second signal line 42. The second pad 52 may be formed with a width wider than the width of the second signal line 42. The second pad 52 may be connected to the second signal line 42 through a second connection line 521. The second connection line 521 may be formed to be bent at a certain angle with respect to the second signal line 42.

The second pad 52 may be provided adjacent to the second signal pad 32. In detail, the second pad 52 may be provided adjacent to the pad connection portion 323 of the second signal pad 32.

The second circuit portion 12 may include a pair of signal lines 43 and 44. The pair of signal lines 43 and 44 may be configured to selectively connect the first signal pad 31 and the second signal pad 32 to second circuit portion 12.

The pair of signal lines, that is, a third signal line 43 and a fourth signal line 44, may be provided parallel to each other on the upper surface of the insulating layer 10, and configured to be connected to the second circuit portion 12. The third signal line 43 and the fourth signal line 44 may be spaced apart from each other by a certain distance and may be formed parallel to each other.

As an example, the third signal line 43 and the fourth signal line 44 of the second circuit portion 12 may be formed symmetrically with the first signal line 41 and the second signal line 42 of the first circuit portion 11. In other words, the third signal line 43 of the second circuit portion 12 may be arranged in a straight line with the first signal line 41 of the first circuit portion 11, and the fourth signal line 44 of the second circuit portion 12 may be arranged in a straight line with the second signal line 42 of the first circuit portion 11.

The first via 21 and the second via 22 may be arranged perpendicular to the first signal line 41 and the second signal line 42. For example, a virtual straight line connecting the first via 21 and the second via 22 may be perpendicular to the first signal line 41 and the second signal line 42. In addition, the first via 21 and the second via 22 may be arranged perpendicular to the third signal line 43 and the fourth signal line 44. For example, the virtual straight line connecting the first via 21 and the second via 22 may be perpendicular to the third signal line 43 and the fourth signal line 44.

One end of the third signal line 43 may be provided adjacent to the first signal pad 31. A third pad 53 may be provided at one end of the third signal line 43. The third pad 53 may be formed with a width wider than the width of the third signal line 43. The third pad 53 may be connected to the third signal line 43 through a third connection line 531. The third connection line 531 may be formed to be bent at a certain angle with respect to the third signal line 43.

The third pad 53 may be provided adjacent to the first signal pad 31. In detail, the third pad 53 may be provided adjacent to the pad connection portion 313 of the first signal pad 31. The third pad 53 may be provided on the opposite side of the first pad 51 based on the pad connection portion 313 of the first signal pad 31.

The third pad 53 and the first pad 51 may be arranged symmetrically with respect to the pad connection portion 313 of the first signal pad 31. For example, the third pad 53 may be arranged to form a straight line with the pad connection portion 313 of the first signal pad 31 and the first pad 51.

One end of the fourth signal line 44 may be provided adjacent to the second signal pad 32. A fourth pad 54 may be provided at one end of the fourth signal line 44. The fourth pad 54 may be formed with a width wider than the width of the fourth signal line 44. The fourth pad 54 may be connected to the fourth signal line 44 through a fourth connection line 541. The fourth connection line 541 may be formed to be bent at a certain angle with respect to the fourth signal line 44.

The fourth pad 54 may be provided adjacent to the second signal pad 32. In detail, the fourth pad 54 may be provided adjacent to the pad connection portion 323 of the second signal pad 32. The fourth pad 54 may be provided on the opposite side of the second pad 52 based on the pad connection portion 323 of the second signal pad 32.

The fourth pad 54 and the second pad 52 may be arranged symmetrically with respect to the pad connection portion 323 of the second signal pad 32. For example, the fourth pad 54 may be arranged to form a straight line with the pad connection portion 323 of the second signal pad 32 and the second pad 52.

The pair of vias, that is, the first via 21 and the second via 22, may be provided outside of the first pad 51 and the second pad 52 connected to the first circuit portion 11 and the third pad 53 and the fourth pad 54 connected to the second circuit portion 12. For example, the first pad 51, the second pad 52, the third pad 53, and the fourth pad 54 may be arranged in a rectangular shape. Accordingly, the first via 21 and the second via 22 may be positioned outside the rectangle formed by the first pad 51, the second pad 52, the third pad 53, and the fourth pad 54. For example, the first via 21 may be located on the upper side of the rectangle, and the second via 22 may be located on the lower side of the rectangle.

The pad connection portion 313 of the first signal pad 31 may be arranged in the center between the first pad 51 of the first signal line 41 and the third pad 53 of the third signal line 43. The pad connection portion 313 of the first signal pad 31 may be arranged between the first pad 51 and the second pad 52 to form a straight line with the first pad 51 and the third pad 53.

The pad connection portion 323 of the second signal pad 32 may be arranged in the center between the second pad 52 of the second signal line 42 and the fourth pad 54 of the fourth signal line 44. The pad connection portion 323 of the second signal pad 32 may be arranged between the second pad 52 and the fourth pad 54 to form a straight line with the second pad 52 and the fourth pad 54.

The first signal pad 31 and the second signal pad 32 may be arranged to form a straight line.

The pair of signal lines 41 and 42 connected to the first circuit portion 11 and the pair of signal lines 43 and 44 connected to the second circuit portion 12 may be connected to the pair of signal pads 31 and 32 by a pair of connecting elements 61 and 62, respectively. For example, the first signal pad 31 may be connected to the first pad 51 of the first signal line 41 connected to the first circuit portion 11 or to the third pad 53 of the third signal line 43 connected to the second circuit portion 12 by a first connecting element 61. The second signal pad 32 may be connected to the second pad 52 of the second signal line 42 connected to the first circuit portion 11 or to the fourth pad 54 of the fourth signal line 44 connected to the second circuit portion 12 by a second connecting element 62.

When using the first circuit portion 11, the first pad 51 of the first signal line 41 is connected to the pad connection portion 313 of the first signal pad 31 by the first connecting element 61, and the second pad 52 of the second signal line 42 is connected to the pad connection portion 323 of the second signal pad 32 by the second connecting element 62. Then, signals transmitted to the first signal pad 31 and the second signal pad 32 through the first via 21 and the second via 22 may be transmitted to the first circuit portion 11 through the first signal line 41 and the second signal line 42.

When using the second circuit portion 12, the third pad 53 of the third signal line 43 is connected to the pad connection portion 313 of the first signal pad 31 by the first connecting element 61, and the fourth pad 54 of the fourth signal line 44 is connected to the pad connection portion 323 of the second signal pad 32 by the second connecting element 62. Then, signals transmitted to the first signal pad 31 and the second signal pad 32 through the first via 21 and the second via 22 may be transmitted to the second circuit portion 12 through the third signal line 43 and the fourth signal line 44.

The connecting elements 61 and 62 are the same as the connecting elements of the printed circuit board 1 according to the above-described embodiment, so detailed descriptions thereof are omitted.

A pair of lower signal lines 71 and 72 may be provided on the lower surface of the insulating layer 10. The pair of lower signal lines 71 and 72 may be spaced apart from each other by a certain distance and may be provided in parallel with each other. The pair of lower signal lines 71 and 72 may be connected to a third circuit portion 13. The third circuit portion 13 may be provided on the lower surface of the insulating layer 10. The third circuit portion 13 may include a processor, a connector, etc.

The pair of vias, that is, the first via 21 and the second via 22, formed to penetrate the insulating layer 10 may be connected to the pair of lower signal lines 71 and 72. The gap between the pair of lower signal lines 71 and 72 may be formed narrower than the gap between the first via 21 and the second via 22.

The lower end of the first via 21 may be connected to one of the pair of lower signal lines 71 and 72 provided on the lower surface of the insulating layer 10, that is, a first lower signal line 71. The lower end of the second via 22 may be connected to the other of the pair of lower signal lines 71 and 72 provided on the lower surface of the insulating layer 10, that is, a second lower signal line 72.

A first lower signal pad 711 may be provided at one end of the first lower signal line 71 connected to the lower end of the first via 21. The first lower signal pad 711 is connected to the lower end of the first via 21. A second lower signal pad 721 may be provided at one end of the second lower signal line 72 connected to the lower end of the second via 22. The second lower signal pad 721 is connected to the lower end of the second via 22. Therefore, the first via 21 and the second via 22 are electrically connected to the first lower signal line 71 and the second lower signal line 72, respectively.

Accordingly, the signals transmitted through the first lower signal line 71 and the second lower signal line 72 may be transmitted to the first via 21 and the second via 22 through the first lower signal pad 711 and the second lower signal pad 721. The signals input to the first via 21 and the second via 22 may be transmitted to the first signal pad 31 and the second signal pad 32.

As illustrated in FIGS. 6 and 7, when the first connecting element 61 is disposed to connect the pad connection portion 313 of the first signal pad 31 and the first pad 51 of the first signal line 41 and the second connecting element 62 is disposed to connect the pad connection portion 323 of the second signal pad 32 and the second pad 52 of the second signal line 42, the signals transmitted to the first signal pad 31 and the second signal pad 32 are transmitted to the first signal line 41 and the second signal line 42 through the first connecting element 61 and the second connecting element 62. Then, the signals of the first lower signal line 71 and the second lower signal line 72 may be transmitted to the first circuit portion 11 through the first signal line 41 and the second signal line 42.

When the first connecting element 61 is disposed to connect the pad connection portion 313 of the first signal pad 31 and the third pad 53 of the third signal line 43 and the second connecting element 62 is disposed to connect the pad connection portion 323 of the second signal pad 32 and the fourth pad 54 of the fourth signal line 44, the signals transmitted to the first signal pad 31 and the second signal pad 32 are transmitted to the third signal line 43 and the fourth signal line 44 through the first connecting element 61 and the second connecting element 62. Then, the signals of the first lower signal line 71 and the second lower signal line 72 may be transmitted to the second circuit portion 12 through the third signal line 43 and the fourth signal line 44.

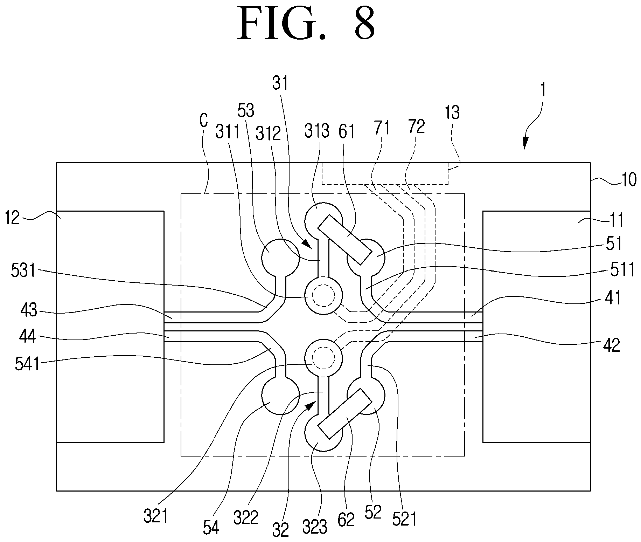

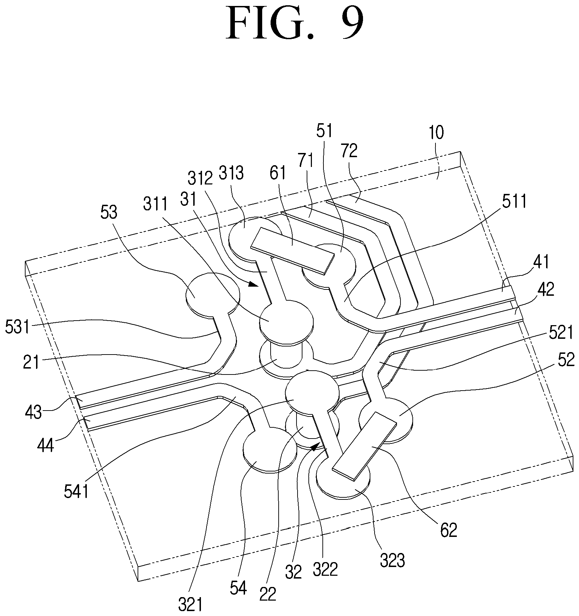

FIG 8 is a plan view illustrating a printed circuit board according to one or more embodiments of the disclosure. FIG 9 is a partial perspective view illustrating a part C of the printed circuit board of FIG 8.

Referring to FIGS. 8 and 9, a printed circuit board 1 according to one or more embodiments of the disclosure may include an insulating layer 10, and a first circuit portion 11 and a second circuit portion 12 provided on an upper surface of the insulating layer 10.

The insulating layer 10 may form a base of the printed circuit board 1. Conductive circuit lines may be provided on the upper surface and the lower surface of the insulating layer 10.

The first circuit portion 11 and the second circuit portion 12 may be provided on the upper surface of the insulating layer 10. The first circuit portion 11 and the second circuit portion 12 may be formed separately. In other words, functions that may be implemented by the first circuit portion 11 may be formed differently from functions that may be implemented by the second circuit portion 12.

The first circuit portion 11 and the second circuit portion 12 may be provided spaced apart from each other by a certain distance on the upper surface of the insulating layer 10. In other words, the first circuit portion 11 and the second circuit portion 12 may be provided so as not to be electrically connected to each other.

A pair of vias 21 and 22 may be provided between the first circuit portion 11 and the second circuit portion 12. The pair of vias 21 and 22 may be formed to penetrate the insulating layer 10. In other words, the pair of vias 21 and 22 may be formed to penetrate a portion of the insulating layer 10 between the first circuit portion 11 and the second circuit portion 12.

The pair of vias, that is, a first via 21 and a second via 22, may be formed at a certain distance apart and parallel to each other. The first via 21 and the second via 22 may be formed of a conductor.

The upper end of the first via 21 may be connected to a first signal pad 31. The first signal pad 31 may be configured to be connected to the upper end of the first via 21 on the upper surface of the insulating layer 10. The first signal pad 31 may be provided between the first circuit portion 11 and the second circuit portion 12. The first signal pad 31 may include only one pad connection portion 313.

The first signal pad 31 may include a via connection portion 311 connected to the upper end of the first via 21, an extension line 312 extended from the via connection portion 311, and the pad connection portion 313 provided at one end of the extension line 312. The extension line 312 may be provided to connect the via connection portion 311 and the pad connection portion 313. The width of the extension line 312 may be formed narrower than the widths of the via connection portion 311 and the pad connection portion 313. In the case of the embodiment illustrated in FIGS. 8 and 9, the extension line 312 may be formed in a straight line.

The first signal pad 31 may be formed in a shape without a branch. In other words, only one extension line 312 is connected to the via connection portion 311. When the first signal pad 31 has a branch, two or more extension lines may be connected to the via connection portion 311. When the first signal pad 31 includes a branch, a signal transmitted to the first signal pad 31 through the first via 21 may branch and flow along two or more extension lines. However, in the case of the disclosure, because the first signal pad 31 does not include a branch, a signal may flow along only one extension line 312.

The upper end of the second via 22 may be connected to a second signal pad 32. The second signal pad 32 may be configured to be connected to the upper end of the second via 22 on the upper surface of the insulating layer 10. The second signal pad 32 may be provided adjacent to the first signal pad 31 between the first circuit portion 11 and the second circuit portion 12. The second signal pad 32 may include only one pad connection portion 323.

The second signal pad 32 may include a via connection portion 321 connected to the upper end of the second via 22, an extension line 322 extending from the via connection portion 321, and the pad connection portion 323 provided at one end of the extension line 322. The extension line 322 may be provided to connect the via connection portion 321 and the pad connection portion 323. The width of the extension line 322 may be formed narrower than the widths of the via connection portion 321 and the pad connection portion 323. In the case of the embodiment illustrated in FIGS. 8 and 9, the extension line 322 may be formed in a straight line.

The second signal pad 32 may be formed in a shape without a branch. In other words, only one extension line 322 is connected to the via connection portion 321. When the second signal pad 32 has a branch, two or more extension lines may be connected to the via connection portion 321. When the second signal pad 32 includes a branch, a signal transmitted to the second signal pad 32 through the second via 22 may branch and flow along two or more extension lines. However, in the case of the disclosure, because the second signal pad 32 does not include a branch, a signal may flow along only one extension line 322.

The first signal pad 31 and the second signal pad 32 may be formed to be symmetrical to each other.

The first circuit portion 11 may include a pair of signal lines 41 and 42. The pair of signal lines 41 and 42 may be configured to selectively connect the first signal pad 31 and the second signal pad 32 to first circuit portion 11.

The pair of signal lines, that is, a first signal line 41 and a second signal line 42, may be provided parallel to each other on the upper surface of the insulating layer 10, and configured to be connected to the first circuit portion 11. The first signal line 41 and the second signal line 42 may be spaced apart from each other by a certain distance and may be formed parallel to each other.

One end of the first signal line 41 may be provided adjacent to the first signal pad 31. A first pad 51 may be provided at one end of the first signal line 41. The first pad 51 may be formed with a width wider than the width of the first signal line 41. The first pad 51 may be connected to the first signal line 41 through a first connection line 511. The first connection line 511 may be formed to be bent at a certain angle with respect to the first signal line 41.

The first pad 51 may be provided adjacent to the first signal pad 31. In detail, the first pad 51 may be provided adjacent to the pad connection portion 313 of the first signal pad 31.

One end of the second signal line 42 may be provided adjacent to the second signal pad 32. A second pad 52 may be provided at one end of the second signal line 42. The second pad 52 may be formed with a width wider than the width of the second signal line 42. The second pad 52 may be connected to the second signal line 42 through a second connection line 521. The second connection line 521 may be formed to be bent at a certain angle with respect to the second signal line 42.

The second pad 52 may be provided adjacent to the second signal pad 32. In detail, the second pad 52 may be provided adjacent to the pad connection portion 323 of the second signal pad 32.

The second circuit portion 12 may include a pair of signal lines 43 and 44. The pair of signal lines 43 and 44 may be configured to selectively connect the first signal pad 31 and the second signal pad 32 to second circuit portion 12.

The pair of signal lines, that is, a third signal line 43 and a fourth signal line 44, may be provided parallel to each other on the upper surface of the insulating layer 10, and configured to be connected to the second circuit portion 12. The third signal line 43 and the fourth signal line 44 may be spaced apart from each other by a certain distance and may be formed parallel to each other.

As an example, the third signal line 43 and the fourth signal line 44 of the second circuit portion 12 may be formed symmetrically with the first signal line 41 and the second signal line 42 of the first circuit portion 11. In other words, the third signal line 43 of the second circuit portion 12 may be arranged in a straight line with the first signal line 41 of the first circuit portion 11, and the fourth signal line 44 of the second circuit portion 12 may be arranged in a straight line with the second signal line 42 of the first circuit portion 11.

The first via 21 and the second via 22 may be arranged perpendicular to the first signal line 41 and the second signal line 42. For example, a virtual straight line connecting the first via 21 and the second via 22 may be perpendicular to the first signal line 41 and the second signal line 42. In addition, the first via 21 and the second via 22 may be arranged perpendicular to the third signal line 43 and the fourth signal line 44. For example, the virtual straight line connecting the first via 21 and the second via 22 may be perpendicular to the third signal line 43 and the fourth signal line 44.

One end of the third signal line 43 may be provided adjacent to the first signal pad 31. A third pad 53 may be provided at one end of the third signal line 43. The third pad 53 may be formed with a width wider than the width of the third signal line 43. The third pad 53 may be connected to the third signal line 43 through a third connection line 531. The third connection line 531 may be formed to be bent at a certain angle with respect to the third signal line 43.

The third pad 53 may be provided adjacent to the first signal pad 31. In detail, the third pad 53 may be provided adjacent to the pad connection portion 313 of the first signal pad 31. The third pad 53 may be provided on the opposite side of the first pad 51 based on the extension line 312 of the first signal pad 31. In other words, the third pad 53 may be arranged symmetrically with respect to the extension line 312 of the first signal pad 31.

One end of the fourth signal line 44 may be provided adjacent to the second signal pad 32. A fourth pad 54 may be provided at one end of the fourth signal line 44. The fourth pad 54 may be formed with a width wider than the width of the fourth signal line 44. The fourth pad 54 may be connected to the fourth signal line 44 through a fourth connection line 541. The fourth connection line 541 may be formed to be bent at a certain angle with respect to the fourth signal line 44.

The fourth pad 54 may be provided adjacent to the second signal pad 32. In detail, the fourth pad 54 may be provided adjacent to the pad connection portion 323 of the second signal pad 32. The fourth pad 54 may be provided on the opposite side of the second pad 52 based on the extension line 322 of the second signal pad 32. In other words, the fourth pad 54 may be arranged symmetrically with respect to the extension line 322 of the second signal pad 32.

The pair of vias, that is, the first via 21 and the second via 22, may be provided inside the first pad 51 and the second pad 52 connected to the first circuit portion 11 and the third pad 53 and the fourth pad 54 connected to the second circuit portion 12. For example, the first pad 51, the second pad 52, the third pad 53, and the fourth pad 54 may be arranged in a rectangular shape. Accordingly, the first via 21 and the second via 22 may be positioned inside the rectangle formed by the first pad 51, the second pad 52, the third pad 53, and the fourth pad 54.

The first signal pad 31 may be arranged to intersect at a right angle with a virtual straight line connecting the first pad 51 and the third pad 53. The second signal pad 32 may be arranged to intersect at a right angle with a virtual straight line connecting the second pad 52 and the fourth pad 54. Accordingly, the pad connection portion 313 of the first signal pad 31 may be located on the upper side of the above-described rectangle, and the pad connection portion 323 of the second signal pad 32 may be located on the lower side of the rectangle.

The first signal pad 31 and the second signal pad 32 may be arranged to form a straight line.

The pair of signal lines 41 and 42 connected to the first circuit portion 11 and the pair of signal lines 43 and 44 connected to the second circuit portion 12 may be connected to the pair of signal pads 31 and 32 by a pair of connecting elements 61 and 62, respectively. For example, the first signal pad 31 may be connected to the first pad 51 of the first signal line 41 connected to the first circuit portion 11 or to the third pad 53 of the third signal line 43 connected to the second circuit portion 12 by a first connecting element 61. The second signal pad 32 may be connected to the second pad 52 of the second signal line 42 connected to the first circuit portion 11 or to the fourth pad 54 of the fourth signal line 44 connected to the second circuit portion 12 by a second connecting element 62.

When using the first circuit portion 11, the first pad 51 of the first signal line 41 is connected to the pad connection portion 313 of the first signal pad 31 by the first connecting element 61, and the second pad 52 of the second signal line 42 is connected to the pad connection portion 323 of the second signal pad 32 by the second connecting element 62. Then, signals transmitted to the first signal pad 31 and the second signal pad 32 through the first via 21 and the second via 22 may be transmitted to the first circuit portion 11 through the first signal line 41 and the second signal line 42.

When using the second circuit portion 12, the third pad 53 of the third signal line 43 is connected to the pad connection portion 313 of the first signal pad 31 by the first connecting element 61, and the fourth pad 54 of the fourth signal line 44 is connected to the pad connection portion 323 of the second signal pad 32 by the second connecting element 62. Then, signals transmitted to the first signal pad 31 and the second signal pad 32 through the first via 21 and the second via 22 may be transmitted to the second circuit portion 12 through the third signal line 43 and the fourth signal line 44.

The connecting elements 61 and 62 are the same as the connecting elements of the printed circuit board 1 according to the above-described embodiment, so detailed descriptions thereof are omitted.

A pair of lower signal lines 71 and 72 may be provided on the lower surface of the insulating layer 10. The pair of lower signal lines 71 and 72 may be spaced apart by a certain distance from each other and may be provided in parallel with each other.

The pair of lower signal lines 71 and 72 may be connected to a third circuit portion 13. The third circuit portion 13 may be provided on the lower surface of the insulating layer 10. The third circuit portion 13 may include a processor, a connector, etc.

The pair of vias, that is, the first via 21 and the second via 22, formed to penetrate the insulating layer 10 may be connected to the pair of lower signal lines 71 and 72. The gap between the pair of lower signal lines 71 and 72 may be formed narrower than the gap between the first via 21 and the second via 22.

The lower end of the first via 21 may be connected to one of the pair of lower signal lines 71 and 72 provided on the lower surface of the insulating layer 10, that is, a first lower signal line 71. The lower end of the second via 22 may be connected to the other of the pair of lower signal lines 71 and 72 provided on the lower surface of the insulating layer 10, that is, a second lower signal line 72.

A first lower signal pad 711 may be provided at one end of the first lower signal line 71 connected to the lower end of the first via 21. The first lower signal pad 711 is connected to the lower end of the first via 21. A second lower signal pad 721 may be provided at one end of the second lower signal line 72 connected to the lower end of the second via 22. The second lower signal pad 721 is connected to the lower end of the second via 22. Therefore, the first via 21 and the second via 22 are electrically connected to the first lower signal line 71 and the second lower signal line 72, respectively.

Accordingly, the signals transmitted through the first lower signal line 71 and the second lower signal line 72 may be transmitted to the first via 21 and the second via 22 through the first lower signal pad 711 and the second lower signal pad 721. The signals input to the first via 21 and the second via 22 may be transmitted to the first signal pad 31 and the second signal pad 32.

As illustrated in FIGS. 8 and 9, when the first connecting element 61 is disposed to connect the pad connection portion 313 of the first signal pad 31 and the first pad 51 of the first signal line 41 and the second connecting element 62 is disposed to connect the pad connection portion 323 of the second signal pad 32 and the second pad 52 of the second signal line 42, the signals transmitted to the first signal pad 31 and the second signal pad 32 are transmitted to the first signal line 41 and the second signal line 42 through the first connecting element 61 and the second connecting element 62. Then, the signals of the first lower signal line 71 and the second lower signal line 72 may be transmitted to the first circuit portion 11 through the first signal line 41 and the second signal line 42.

When the first connecting element 61 is disposed to connect the pad connection portion 313 of the first signal pad 31 and the third pad 53 of the third signal line 43 and the second connecting element 62 is disposed to connect the pad connection portion 323 of the second signal pad 32 and the fourth pad 54 of the fourth signal line 44, the signals transmitted to the first signal pad 31 and the second signal pad 32 are transmitted to the third signal line 43 and the fourth signal line 44 through the first connecting element 61 and the second connecting element 62. Then, the signals of the first lower signal line 71 and the second lower signal line 72 may be transmitted to the second circuit portion 12 through the third signal line 43 and the fourth signal line 44.

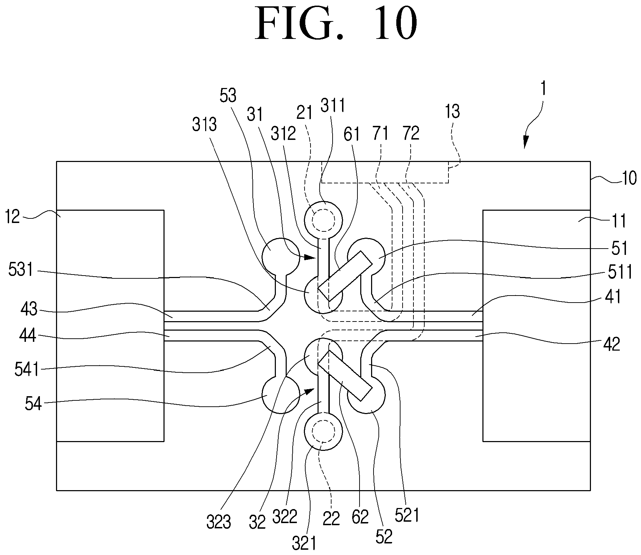

FIG 10 is a plan view illustrating a printed circuit board according to one or more embodiments of the disclosure.

Referring to FIG 10, a printed circuit board 1 according to one or more embodiments of the disclosure may include an insulating layer 10, and a first circuit portion 11 and a second circuit portion 12 provided on an upper surface of the insulating layer 10.

The insulating layer 10, the first circuit portion 11, and the second circuit portion 12 are the same as those in the above-described embodiment, so detailed descriptions thereof are omitted.

The first circuit portion 11 may include a pair of signal lines, that is, a first signal line 41 and a second signal line 42.

The second circuit portion 12 may include a pair of signal lines, that is, a third signal line 43 and a fourth signal line 44.

The first signal line 41, the second signal line 42, the third signal line 43, and the fourth signal line 44 are the same as or similar to those in the above-described embodiment, so detailed descriptions thereof are omitted.

A pair of vias 21 and 22 may be provided between the first circuit portion 11 and the second circuit portion 12. The pair of vias 21 and 22 may be formed to penetrate the insulating layer 10. In other words, the pair of vias 21 and 22 may be formed to penetrate a portion of the insulating layer 10 between the first circuit portion 11 and the second circuit portion 12.

The pair of vias, that is, a first via 21 and a second via 22, may be formed parallel to each other and spaced apart from each other by a certain distance. The first via 21 and the second via 22 may be formed of a conductor. The first via 21 and the second via 22 may be arranged to be perpendicular to the first signal line 41 and the second signal line 42. In other words, a virtual straight line connecting the first via 21 and the second via 22 may be perpendicular to the first signal line 41 and the second signal line 42. The first via 21 and the second via 22 may be arranged to be perpendicular to the third signal line 43 and the fourth signal line 44. In other words, the virtual straight line connecting the first via 21 and the second via 22 may be perpendicular to the third signal line 43 and the fourth signal line 44.

The upper end of the first via 21 may be connected to a first signal pad 31. The first signal pad 31 may be configured to be connected to the upper end of the first via 21 on the upper surface of the insulating layer 10. The first signal pad 31 may be provided between the first circuit portion 11 and the second circuit portion 12. The first signal pad 31 may include only one pad connection portion 313.

The first signal pad 31 may include a via connection portion 311 connected to the upper end of the first via 21, an extension line 312 extended from the via connection portion 311, and the pad connection portion 313 provided at one end of the extension line 312. The extension line 312 may be provided to connect the via connection portion 311 and the pad connection portion 313. The width of the extension line 312 may be formed narrower than the widths of the via connection portion 311 and the pad connection portion 313. In the case of the embodiment illustrated in FIG 10, the extension line 312 may be formed in a straight line.

The first signal pad 31 may be formed in a shape without a branch. In other words, only one extension line 312 is connected to the via connection portion 311. When the first signal pad 31 has a branch, two or more extension lines may be connected to the via connection portion 311. When the first signal pad 31 includes a branch, a signal transmitted to the first signal pad 31 through the first via 21 may branch and flow along two or more extension lines. However, in the case of the disclosure, because the first signal pad 31 does not include a branch, a signal may flow along only one extension line 312.

The upper end of the second via 22 may be connected to a second signal pad 32. The second signal pad 32 may be configured to be connected to the upper end of the second via 22 on the upper surface of the insulating layer 10. The second signal pad 32 may be provided adjacent to the first signal pad 31 between the first circuit portion 11 and the second circuit portion 12. The second signal pad 32 may include only one pad connection portion 323.

The second signal pad 32 may include a via connection portion 321 connected to the upper end of the second via 22, an extension line 322 extended from the via connection portion 321, and the pad connection portion 323 provided at one end of the extension line 322. The extension line 322 may be provided to connect the via connection portion 321 and the pad connection portion 323. The width of the extension line 322 may be formed narrower than the widths of the via connection portion 321 and the pad connection portion 323. In the case of the embodiment illustrated in FIG 10, the extension line 322 of the second signal pad 32 may be formed in a straight line.

The second signal pad 32 may be formed in a shape without a branch. In other words, only one extension line 322 is connected to the via connection portion 321. When the second signal pad 32 has a branch, two or more extension lines may be connected to the via connection portion 321. When the second signal pad 32 includes a branch, a signal transmitted to the second signal pad 32 through the second via 22 may branch and flow along two or more extension lines. However, in the case of the disclosure, because the second signal pad 32 does not include a branch, a signal may flow along only one extension line 322.

The first signal pad 31 and the second signal pad 32 may be formed to be symmetrical to each other.

The pair of vias, that is, the first via 21 and the second via 22, may be provided outside of the first pad 51 and the second pad 52 connected to the first circuit portion 11 and the third pad 53 and the fourth pad 54 connected to the second circuit portion 12. For example, the first pad 51, the second pad 52, the third pad 53, and the fourth pad 54 may be arranged in a rectangular shape. Accordingly, the first via 21 and the second via 22 may be positioned outside the rectangle formed by the first pad 51, the second pad 52, the third pad 53, and the fourth pad 54. For example, the first via 21 may be located on the upper side of the above-described rectangle, and the second via 22 may be located on the lower side of the rectangle.

The pad connection portion 313 of the first signal pad 31 and the pad connection portion 323 of the second signal pad 32 may be located inside the rectangle formed by the first pad 51, the second pad 52, the third pad 53, and the fourth pad 54.

The pad connection portion 313 of first signal pad 31 may be positioned below a virtual straight line connecting the first pad 51 of the first signal line 41 and the third pad 53 of the third signal line 43. The first pad 51 and the third pad 53 may be arranged symmetrically with respect to the extension line 312 of the first signal pad 31.

The pad connection portion 323 of second signal pad 32 may be positioned above a virtual straight line connecting the second pad 52 of the second signal line 42 and the fourth pad 54 of the fourth signal line 44. The second pad 52 and the fourth pad 54 may be arranged symmetrically with respect to the extension line 322 of the second signal pad 32.

The first signal pad 31 and the second signal pad 32 may be arranged to form a straight line.

The first signal pad 31 may be connected to the first pad 51 of the first signal line 41 connected to the first circuit portion 11 or to the third pad 53 of the third signal line 43 connected to the second circuit portion 12 by a first connecting element 61. The second signal pad 32 may be connected to the second pad 52 of the second signal line 42 connected to the first circuit portion 11 or to the fourth pad 54 of the fourth signal line 44 connected to the second circuit portion 12 by a second connecting element 62. The first and second connecting elements 61 and 62 are the same as the connecting elements of the printed circuit board 1 according to the above-described embodiment, so detailed descriptions thereof are omitted.

A pair of lower signal lines 71 and 72 connected to the first via 21 and the second via 22 may be provided on the lower surface of the insulating layer 10. The pair of lower signal lines 71 and 72 are the same as or similar to the pair of lower signal lines 71 and 72 of the printed circuit board 1 according to the above-described embodiment, so detailed descriptions thereof are omitted.

The operation of selectively transmitting signals of the pair of lower signal lines 71 and 72 to one of the first circuit portion 11 and the second circuit portion 12 through the pair of vias 21 and 22 and the pair of connecting elements 61 and 62 is the same as that of the printed circuit board 1 according to the above-described embodiment, so a detailed description thereof is omitted.

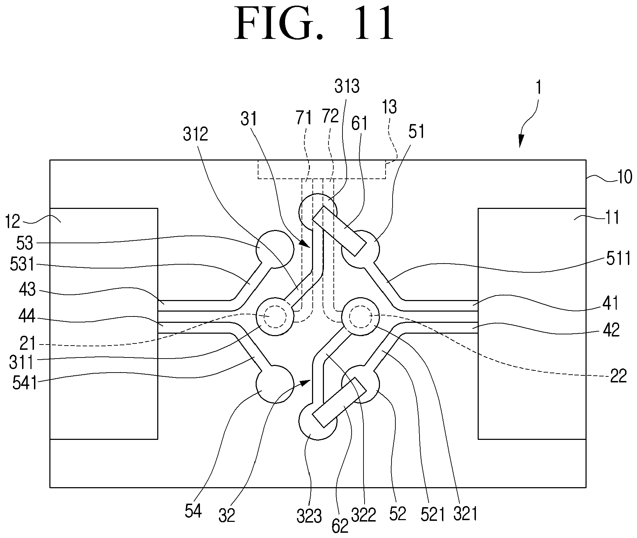

FIG 11 is a plan view illustrating a printed circuit board according to one or more embodiments of the disclosure.

Referring to FIG 11, a printed circuit board 1 according to one or more embodiments of the disclosure may include an insulating layer 10, and a first circuit portion 11 and a second circuit portion 12 provided on an upper surface of the insulating layer 10.

The insulating layer 10, the first circuit portion 11, and the second circuit portion 12 are the same as those in the above-described embodiment, so detailed descriptions thereof are omitted.

The first circuit portion 11 may include a pair of signal lines, that is, a first signal line 41 and a second signal line 42.

The second circuit portion 12 may include a pair of signal lines, that is, a third signal line 43 and a fourth signal line 44.

The first signal line 41, the second signal line 42, the third signal line 43, and the fourth signal line 44 are the same as or similar to those in the above-described embodiment, so detailed descriptions thereof are omitted.

A pair of vias 21 and 22 may be provided between the first circuit portion 11 and the second circuit portion 12. The pair of vias 21 and 22 may be formed to penetrate the insulating layer 10. In other words, the pair of vias 21 and 22 may be formed to penetrate a portion of the insulating layer 10 between the first circuit portion 11 and the second circuit portion 12.

The pair of vias, that is, a first via 21 and a second via 22, may be formed to be spaced apart from each other by a certain distance and parallel to each other. The first via 21 and the second via 22 may be formed of a conductor. The first via 21 and the second via 22 may be provided parallel to the first signal line 41 and the second signal line 42. In other words, a virtual straight line connecting the first via 21 and the second via 22 may be parallel to the first signal line 41 and the second signal line 42.

In addition, the first via 21 and the second via 22 may be provided parallel to the third signal line 43 and the fourth signal line 44. In other words, the virtual straight line connecting the first via 21 and the second via 22 may be parallel to the third signal line 43 and the fourth signal line 44.

The upper end of the first via 21 may be connected to a first signal pad 31. The first signal pad 31 may be configured to be connected to the upper end of the first via 21 on the upper surface of the insulating layer 10. The first signal pad 31 may be provided between the first circuit portion 11 and the second circuit portion 12. The first signal pad 31 may include only one pad connection portion 313.

The first signal pad 31 may include a via connection portion 311 connected to the upper end of the first via 21, an extension line 312 extended from the via connection portion 311, and the pad connection portion 313 provided at one end of the extension line 312. The extension line 312 may be provided to connect the via connection portion 311 and the pad connection portion 313. The width of the extension line 312 may be formed narrower than the widths of the via connection portion 311 and the pad connection portion 313. In the case of the embodiment illustrated in FIG. 11, the extension line 312 may be formed in a straight line bent at a certain angle.

The first signal pad 31 may be formed in a shape without a branch. In other words, only one extension line 312 is connected to the via connection portion 311. When the first signal pad 31 has a branch, two or more extension lines may be connected to the via connection portion 311. When the first signal pad 31 includes a branch, a signal transmitted to the first signal pad 31 through the first via 21 may branch and flow along two or more extension lines. However, in the case of the disclosure, because the first signal pad 31 does not include a branch, a signal may flow along only one extension line 312.

The upper end of the second via 22 may be connected to a second signal pad 32. The second signal pad 32 may be configured to be connected to the upper end of the second via 22 on the upper surface of the insulating layer 10. The second signal pad 32 may be provided adjacent to the first signal pad 31 between the first circuit portion 11 and the second circuit portion 12. The second signal pad 32 may include only one pad connection portion 323.

The second signal pad 32 may include a via connection portion 321 connected to the upper end of the second via 22, an extension line 322 extended from the via connection portion 321, and the pad connection portion 323 provided at one end of the extension line 322. The extension line 322 may be provided to connect the via connection portion 321 and the pad connection portion 323. The width of the extension line 322 may be formed narrower than the widths of the via connection portion 321 and the pad connection portion 323. In the case of the embodiment illustrated in FIG 11, the extension line 322 of the second signal pad 32 may be formed in a straight line bent at a certain angle.

The second signal pad 32 may be formed in a shape without a branch. In other words, only one extension line 322 is connected to the via connection portion 321. When the second signal pad 32 has a branch, two or more extension lines may be connected to the via connection portion 321. When the second signal pad 32 includes a branch, a signal transmitted to the second signal pad 32 through the second via 22 may branch and flow along two or more extension lines. However, in the case of the disclosure, because the second signal pad 32 does not include a branch, a signal may flow along only one extension line 322.

The first signal pad 31 and the second signal pad 32 may be formed to be symmetrical to each other.

The pair of vias, that is, the first via 21 and the second via 22, may be provided inside the first pad 51 and the second pad 52 connected to the first circuit portion 11 and the third pad 53 and the fourth pad 54 connected to the second circuit portion 12. For example, the first pad 51, the second pad 52, the third pad 53, and the fourth pad 54 may be arranged in a rectangular shape. Accordingly, the first via 21 and the second via 22 may be positioned inside the rectangle formed by the first pad 51, the second pad 52, the third pad 53, and the fourth pad 54.

The pad connection portion 313 of the first signal pad 31 and the pad connection portion 323 of the second signal pad 32 may be located outside of the rectangle formed by the first pad 51, the second pad 52, the third pad 53, and the fourth pad 54. The pad connection portion 313 of first signal pad 31 may be positioned above a virtual straight line connecting the first pad 51 of the first signal line 41 and the third pad 53 of the third signal line 43. The first pad 51 and the third pad 53 may be arranged symmetrically with respect to the extension line 312 of the first signal pad 31.

The pad connection portion 323 of second signal pad 32 may be placed below a virtual straight line connecting the second pad 52 of the second signal line 42 and the fourth pad 54 of the fourth signal line 44. The second pad 52 and the fourth pad 54 may be arranged symmetrically with respect to the extension line 322 of the second signal pad 32.

The first signal pad 31 may be connected to the first pad 51 of the first signal line 41 connected to the first circuit portion 11 or to the third pad 53 of the third signal line 43 connected to the second circuit portion 12 by a first connecting element 61. The second signal pad 32 may be connected to the second pad 52 of the second signal line 42 connected to the first circuit portion 11 or to the fourth pad 54 of the fourth signal line 44 connected to the second circuit portion 12 by a second connecting element 62.

The first and second connecting elements 61 and 62 are the same as the connecting elements of the printed circuit board 1 according to the above-described embodiment, so detailed descriptions thereof are omitted.

A pair of lower signal lines 71 and 72 connected to the lower ends of the first via 21 and the second via 22 may be provided on the lower surface of the insulating layer 10. The pair of lower signal lines 71 and 72 are the same as or similar to the pair of lower signal lines 71 and 72 of the printed circuit board 1 according to the above-described embodiment, so detailed descriptions thereof are omitted.

The operation of selectively transmitting signals of the pair of lower signal lines 71 and 72 to one of the first circuit portion 11 and the second circuit portion 12 through the pair of vias 21 and 22 and the pair of connecting elements 61 and 62 is the same as that of the printed circuit board 1 according to the above-described embodiment, so a detailed description thereof is omitted.

The printed circuit board 1 according to one or more embodiments of the disclosure may reduce insertion loss.

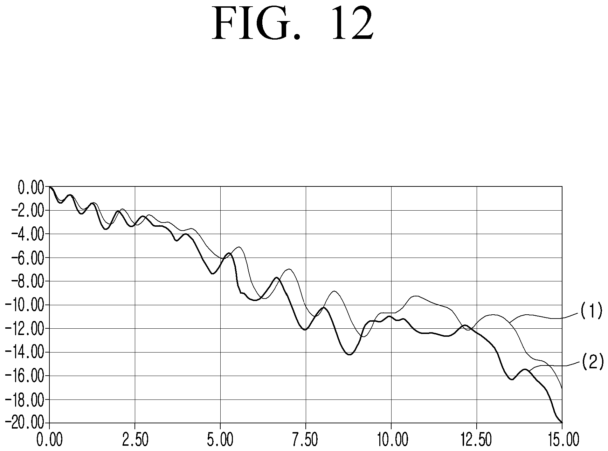

FIG 12 is a graph comparing the insertion loss of a printed circuit board having a signal pad without a branch according to one or more embodiments of the disclosure and the insertion loss of a printed circuit board having a signal pad with a branch.

For reference, in FIG 12, the vertical axis represents the insertion loss, and the horizontal axis represents the frequency of a signal. The insertion loss of the printed circuit board may be measured using an oscilloscope. In addition, a curve (1) represents the insertion loss of a printed circuit board according to one or more embodiments of the disclosure having a pair of signal pads without a branch, and a curve (2) represents the insertion loss of a printed circuit board having a pair of signal pads with a branch.

Referring to FIG. 12, it may be seen that a printed circuit board having a pair of signal pads without a branch according to one or more embodiments of the disclosure has reduced insertion loss across the entire frequency band compared to a printed circuit board having a pair of signal pads with a branch, as illustrated in FIG 4.

A printed circuit board according to one or more embodiments of the disclosure may reduce noise. In detail, when a signal pad without a branch, such as a printed circuit board according to one or more embodiments of the disclosure, is used, noise may be reduced compared to a printed circuit board using a signal pad with a branch.

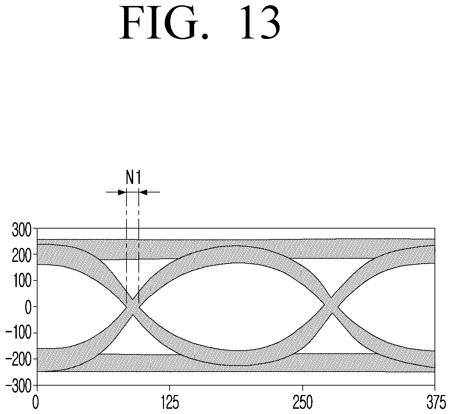

Hereinafter, with reference to FIGS. 13, 14, and 15, noise of a two-layer printed circuit board using a signal pad without a branch according to one or more embodiments of the disclosure is compared with noise of a two-layer printed circuit board using a signal pad with a branch and noise of a four-layer printed circuit board using a signal pad with a branch using an eye diagram.

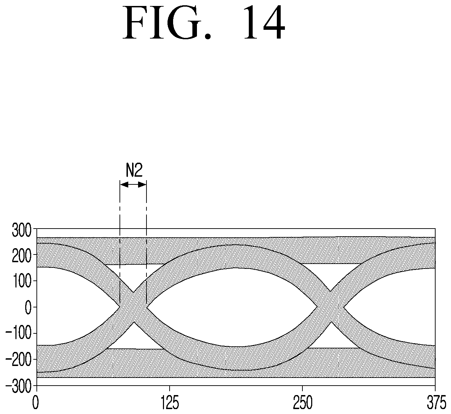

FIG 13 is an eye diagram of a two-layer printed circuit board according to one or more embodiments of the disclosure using a pair of signal pads without a branch. FIG 14 is an eye diagram of a two-layer printed circuit board using a signal pad with a branch. For reference, the vertical axis of the eye diagram represents voltage V and the horizontal axis thereof represents time s.

In FIGS. 13 and 14, the parts indicated by N1 and N2 represent noise of the printed circuit board, and the widths of N1 and N2 represent the size of the noise.

Comparing FIGS. 13 and 14, the width of N1 is narrower than the width of N2. Therefore, it may be seen that the noise of the two-layer printed circuit board according to one or more embodiments of the disclosure using a pair of signal pads without a branch is reduced compared to the noise of the two-layer printed circuit board using a pair of signal pads with a branch.

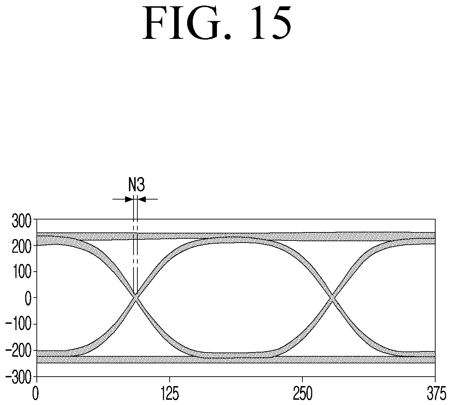

FIG 15 is an eye diagram of a four-layer printed circuit board using a signal pad with a branch. In FIG 15, the part indicated by N3 represents noise of the printed circuit board, and the width of N3 represents the size of the noise.

Comparing FIGS. 13 and 15, the width of N1 is slightly wider than the width of N3. Therefore, it may be seen that the noise of the two-layer printed circuit board according to one or more embodiments of the disclosure using a pair of signal pads without a branch is reduced similarly to the noise of the four-layer printed circuit board using a pair of signal pads with a branch.

In other words, the two-layer printed circuit board according to one or more embodiments of the disclosure may achieve similar performance to an expensive four-layer printed circuit board by using signal pads without a branch. Therefore, the printed circuit board according to one or more embodiments of the disclosure may reduce the manufacturing cost.

In the above, the printed circuit board according to one or more embodiments of the disclosure has been described as an example in which a signal line is selectively connected to one of two circuit portions, but the disclosure is not limited thereto. The disclosure may also be applied to a printed circuit board in which a signal line is selectively connected to one of three or more circuit portions.

In the above, a two-layer printed circuit board in which circuit portions are formed on the upper and lower surfaces of an insulating layer has been described as an example of a printed circuit board according to one or more embodiments of the disclosure, but the disclosure is not limited thereto. The disclosure may also be applied to a multilayer printed circuit board such as a four-layer printed circuit board.

In the foregoing, the disclosure has been shown and described with reference to various embodiments. However, it is understood by those skilled in the art that various changes may be made in form and detail without departing from the scope of the disclosure as defined by the appended claims and equivalents thereof.

## Claims

1. A printed circuit board comprising:
an insulating layer;
a first circuit portion and a second circuit portion provided on an upper surface of the insulating layer;
a first via and a second via provided between the first circuit portion and the second circuit portion, and penetrating the insulating layer;
a first signal pad provided between the first circuit portion and the second circuit portion on the upper surface of the insulating layer and configured to be connected to an upper end of the first via, and having only one pad connection portion;
a second signal pad provided adjacent to the first signal pad between the first circuit portion and the second circuit portion on the upper surface of the insulating layer and configured to be connected to an upper end of the second via, and having only one pad connection portion;
a first signal line connected to the first circuit portion on the upper surface of the insulating layer and including a first pad provided adjacent to the first signal pad;
a second signal line connected to the first circuit portion in parallel with the first signal line on the upper surface of the insulating layer and including a second pad provided adjacent to the second signal pad;
a third signal line connected to the second circuit portion on the upper surface of the insulating layer and including a third pad provided adjacent to the first signal pad;
a fourth signal line connected to the second circuit portion in parallel with the third signal line on the upper surface of the insulating layer and including a fourth pad provided adjacent to the second signal pad;
a first connecting element configured to connect the pad connection portion of the first signal pad to one of the first pad and the third pad; and
a second connecting element configured to connect the pad connection portion of the second signal pad to one of the second pad and the fourth pad.

2. The printed circuit board of claim 1, wherein
based on using the first circuit portion, the first connecting element is disposed to connect the pad connection portion of the first signal pad and the first pad, and the second connecting element is disposed to connect the pad connection portion of the second signal pad and the second pad, and
wherein based on using the second circuit portion, the first connecting element is disposed to connect the pad connection portion of the first signal pad and the third pad, and the second connecting element is disposed to connect the pad connection portion of the second signal pad and the fourth pad.

3. The printed circuit board of claim 1, wherein
the second circuit portion is provided separately from the first circuit portion on the upper surface of the insulating layer.

4. The printed circuit board of claim 1, further comprising:
a pair of lower signal lines provided on a lower surface of the insulating layer,
wherein a lower end of the first via and a lower end of the second via are respectively connected to the pair of lower signal lines.

5. The printed circuit board of claim 1, wherein
the first via and the second via are provided inside the first pad, the second pad, the third pad, and the fourth pad.

6. The printed circuit board of claim 5, wherein
the first pad of the first signal line and the third pad of the third signal line are provided symmetrically with respect to the pad connection portion of the first signal pad, and
wherein the second pad of the first signal line and the fourth pad of the fourth signal line are provided symmetrically with respect to the pad connection portion of the second signal pad.

7. The printed circuit board of claim 5, wherein
the pad connection portion of the first signal pad is positioned in a straight line with the first pad of the first signal line and the third pad of the third signal line, and
the pad connection portion of the second signal pad is positioned in a straight line with the second pad of the second signal line and the fourth pad of the fourth signal line.

8. The printed circuit board of claim 5, wherein
the pad connection portion of the first signal pad is positioned outside of a virtual straight line connecting the first pad of the first signal line and the third pad of the third signal line, and
the pad connection portion of the second signal pad is positioned outside of a virtual straight line connecting the second pad of the second signal line and the fourth pad of the fourth signal line.

9. The printed circuit board of claim 1, wherein
the first via and the second via are provided outside the first pad, the second pad, the third pad, and the fourth pad.

10. The printed circuit board of claim 9, wherein
the first pad of the first signal line and the third pad of the third signal line are provided symmetrically with respect to the pad connection portion of the first signal pad, and
wherein the second pad of the first signal line and the fourth pad of the fourth signal line are provided symmetrically with respect to the pad connection portion of the second signal pad.

11. The printed circuit board of claim 9, wherein
the pad connection portion of the first signal pad is positioned in a straight line with the first pad of the first signal line and the third pad of the third signal line, and
the pad connection portion of the second signal pad is positioned in a straight line with the second pad of the second signal line and the fourth pad of the fourth signal line.

12. The printed circuit board of claim 9, wherein
the pad connection portion of the first signal pad is positioned above a virtual straight line connecting the first pad of the first signal line and the third pad of the third signal line, and
the pad connection portion of the second signal pad is positioned below a virtual straight line connecting the second pad of the second signal line and the fourth pad of the fourth signal line.

13. The printed circuit board of claim 1, wherein
a gap between the pad connection portion of the first signal pad and the first pad is identical to a gap between the pad connection portion of the first signal pad and the third pad, and
a gap between the pad connection portion of the second signal pad and the second pad is identical to a gap between the pad connection portion of the second signal pad and the fourth pad.

14. The printed circuit board of claim 13, wherein
a gap between the pad connection portion of the first signal pad and the first pad is identical to a gap between the pad connection portion of the second signal pad and the second pad, and
a gap between the pad connection portion of the first signal pad and the third pad is identical to a gap between the pad connection portion of the second signal pad and the fourth pad.

15. The printed circuit board of claim 1, wherein
the first connecting element and the second connecting element include one of a resistor, a filter, a capacitor, and a conductor.
